(19) Europäisches Patentamt

European Patent Office

Office européen des brevets

(11) **EP 1 212 814 B1**

(12) **FASCICULE DE BREVET EUROPEEN**

(45) Date de publication et mention
de la délivrance du brevet:
**01.05.2019 Bulletin 2019/18**

(21) Numéro de dépôt: **01945399.2**

(22) Date de dépôt: **12.06.2001**

(51) Int Cl.:
***H01S 3/0941*** (2006.01)

(86) Numéro de dépôt international:
**PCT/FR2001/001813**

(87) Numéro de publication internationale:
**WO 2002/001683 (03.01.2002 Gazette 2002/01)**

(54) **LASER POMPE ET MILIEU LASER OPTIMISE**

GEPUMPTER LASER UND OPTIMIERTES LASERMEDIUM

PUMPED LASER AND OPTIMISED LASING MEDIUM

(84) Etats contractants désignés:
**DE**

(30) Priorité: **30.06.2000 FR 0008519**

(43) Date de publication de la demande:
**12.06.2002 Bulletin 2002/24**

(73) Titulaire: **Thales**
**92400 Courbevoie (FR)**

(72) Inventeurs:
• **FEUGNET, Gilles,**
**Thales Intellectual Property**
**94117 Arcueil Cedex (FR)**
• **LALLIER, Eric,**
**Thales Intellectual Property**
**94117 Arcueil Cedex (FR)**
• **LARAT, Christian,**
**Thales Intellectual Property**
**94117 Arcueil Cedex (FR)**
• **POCHOLLE, Jean-Paul,**
**Thales Intellectual Property**
**94117 Arcueil Cedex (FR)**

• **ROLLY, Didier,**
**Thales Intellectual Property**
**94117 Arcueil cedex (FR)**

(74) Mandataire: **Dudouit, Isabelle et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A- 0 570 743      JP-A- H07 321 394**
**US-A- 5 877 890**

• **FEUGNET G ET AL: "HIGH-EFFICIENCY TEM00
ND:YVO4 LASER LONGITUDINALLY PUMPED
BY A HIGH-POWER ARRAY" OPTICS
LETTERS,US,OPTICAL SOCIETY OF AMERICA,
WASHINGTON, vol. 20, no. 2, 15 janvier 1995
(1995-01-15), pages 157-159, XP000486637 ISSN:
0146-9592**

## Description

[0001] L'invention concerne les lasers pompés et les milieux lasers optimisés.

[0002] Elle s'applique plus particulièrement aux lasers pompés diode, par exemple un laser pompé diode comportant une optique de couplage simple.

[0003] Elle peut aussi être utilisée comme un amplificateur de faisceaux de type lasers.

[0004] La géométrie de pompage des lasers pompés par lampe est quasiment exclusivement une géométrie de pompage dite transversale, c'est-à-dire que la direction de propagation du faisceau dans la cavité optique et la plus grande dimension des lampes sont parallèles. La lumière émise par les lampes pénètre dans le milieu laser par ses faces transverses.

[0005] Les diodes lasers dont l'émission est plus directive que celle d'une lampe permettent d'envisager une autre géométrie de pompage dite longitudinale. Le faisceau de pompe et le faisceau laser se propagent alors selon des directions voisines, le rendement du laser étant favorisé lorsque ces deux faisceaux se superposent avec des sections voisines dans le milieu laser. Il est aussi possible de favoriser un fonctionnement sur le mode fondamental $TEM_{00}$ de la cavité stable lorsque la dimension du faisceau pompe est voisine de la dimension du mode fondamental.

[0006] Les faisceaux lasers fondamentaux des cavités stables ont des sections circulaires ou plus moins elliptiques qui ne coïncident pas nécessairement avec la forme des surfaces émissives des diodes lasers. Pour obtenir la superposition du faisceau pompe avec le faisceau du laser il est connu d'utiliser un système optique de focalisation ou de remise en forme de la lumière émise.

[0007] Par exemple, la réalisation d'un laser pompé longitudinalement nécessite l'emploi d'un système optique focalisant la lumière émise par une ou plusieurs barrettes de diodes laser de puissance.

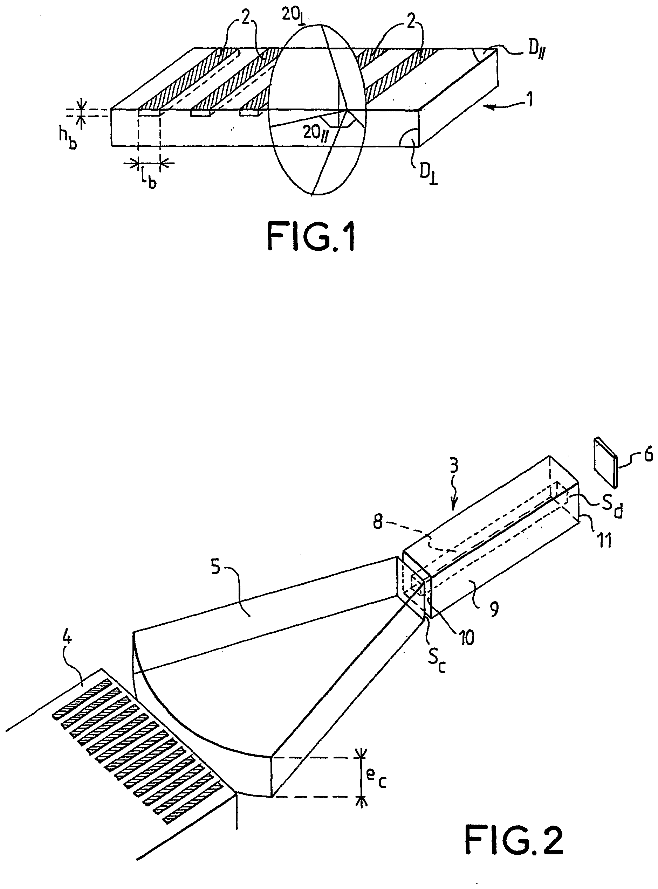

[0008] La figure 1 montre un exemple d'une barrette 1 de diode laser comportant plusieurs diodes laser élémentaires 2 disposées côte à côte. Les diodes laser ont chacune une zone émissive dont la largeur $l_b$ varie de quelques microns à quelques centaines de microns par exemple, et une hauteur $h_b$ de l'ordre du micron. L'étendue de la zone d'émission s'avère de ce fait très dissymétrique. En effet, les barrettes ont généralement une dimension d'environ 1 cm et une divergence $\theta_{/\!/}$ de l'ordre de 10° dans le plan $D_{/\!/}$ parallèle à la jonction. Dans le plan $D_\perp$ à la jonction, la dimension est de l'ordre de 1 $\mu$m et la divergence $\theta\perp$ de 50°. Ainsi, l'étendue géométrique d'une barrette est environ 2000 fois plus grande selon le plan $D_{/\!/}$ que selon le plan $D_\perp$. La forte valeur de l'étendue géométrique dans le plan $D_{/\!/}$ et la forte dissymétrie entre $D_{/\!/}$ et $D_\perp$ rendent difficile la conception de systèmes optiques de focalisation de la lumière émise avec le milieu laser actif.

[0009] Compte tenu des caractéristiques actuelles des barrettes de puissance, la lumière émise peut être focalisée sur une tache de 1 à 2 mm environ de diamètre avec des rendements d'au moins 70 % (rapport entre la puissance moyenne transmise et la puissance moyenne émise).

[0010] En sortie d'un tel système optique la lumière est très divergente ce qui est fâcheux car :

- le seuil d'oscillation du laser augmente avec le volume dans lequel l'énergie de pompe est déposée, et
- un fonctionnement multimode peut être induit si ce volume est plus grand que le volume occupé par le mode fondamental de la cavité.

[0011] Il est connu pour diminuer ces phénomènes d'utiliser des cristaux fortement dopés, le volume nécessaire pour absorber la puissance de pompe diminuant lorsque le coefficient d'absorption augmente. Cette solution présente néanmoins certains inconvénients, par exemple :

- favoriser l'apparition d'aberrations, de contraintes et de biréfringences d'origine thermique, la correction de ces effets devient difficile et le mode de fonctionnement en mode $TEM_{00}$ n'est plus possible,
- réduire l'énergie de pompe susceptible d'être déposée sans atteindre le seuil d'endommagement du matériau, et
- limiter le choix des matériaux lasers.

[0012] Il est aussi connu de l'art antérieur d'utiliser des milieux lasers dopés de façon non homogène.

[0013] Par exemple, certains lasers ayant une géométrie de pompage transversale utilisent des milieux dopés non uniformément afin de sélectionner le mode souhaité.

[0014] Dans d'autres applications, les barreaux lasers pompés longitudinalement ont une géométrie telle que la section du barreau est très petite devant la longueur utilisant le guidage de la lumière de pompe par réflexion totale sur la périphérie du barreau. Toutefois, la sélection de mode par le dopage n'est pas réalisée. Un exemple de réalisation est donné dans les références E.C.Honea and al, Optics Letters, p 1203, OSA 1998 ou E.C.Honea and al, Optics Letters, p 154, OSA 1999.

[0015] JP H07 321394 A décrit un barreau laser à dopage non homogène.

[0016] L'idée de l'invention consiste, notamment, à utiliser comme milieu actif laser un matériau dopé de manière non homogène, comportant une ou plusieurs zones dans laquelle ou lesquelles, la distribution des dopants est notamment choisie en fonction d'un mode du laser favorisé, tel que le mode transversal souhaité.

[0017] Elle repose aussi sur l'association d'un système optique de focalisation simple traitant de façon globale la source lumineuse issue de la diode avec le milieu actif laser non uniformément dopé.

[0018] L'invention concerne un laser pompé longitudinalement comprenant un ou plusieurs milieux actifs lasers disposés dans une cavité optique et au moins un

moyen de pompage émettant au moins un faisceau de pompe vers le ou les milieux actifs lasers, des moyens de couplage du ou des faisceaux de pompe avec le milieu actif. Il est caractérisé en ce qu'au moins un des milieux actifs lasers comporte une ou plusieurs zones dopées de façon non homogène et en ce que la dimension desdites zones dopées et/ou la répartition des dopants est choisie en fonction du mode transversal de la cavité laser souhaité.

La zone dopée est disposée par exemple de manière sensiblement centrale dans le milieu actif, ses dimensions sont adaptées au mode fondamental de la cavité laser ou au mode transversal et la zone périphérique non dopée a des dimensions adaptées au moyen de couplage.

La section $s_d$ de la face d'entrée de la zone dopée qui reçoit le faisceau de pompe est par exemple inférieure ou égale à la section $s_m$ du mode fondamental de la cavité.

La section $s_d$ de la face d'entrée de la zone dopée qui reçoit le faisceau de pompe peut être au moins supérieure à la section $s_m$ du mode fondamental de la cavité, la cavité laser comportant un dispositif de sélection.

Selon un autre mode de réalisation le milieu laser actif comporte une zone centrale non dopée entourée d'une zone périphérique dopée.

La zone dopée a par exemple une forme parallélipipédique ou circulaire ou elliptique.

Le ou les moyens de pompage peuvent comporter une ou plusieurs barrettes de diode et les moyens de couplage être constitués d'un concentrateur de lumière adapté à recevoir l'ensemble de la lumière émise par les barrettes de diodes.

Les moyens de couplage comportent par exemple au moins un des dispositifs choisis dans la liste suivante : un système de focalisation par réfraction ou un système par diffraction ou un système par réflexion ou un système de remise en forme de l'étendue d'un faisceau.

La distribution des dopants dans le milieu actif est par exemple réalisée selon un gradient.

Les dopants sont par exemple choisis parmi un ou plusieurs des ions de la liste suivante : ($Nd^{3+}$, $Yb^{3+}$, $Er^{3+}$, $Ho^{3+}$, $Th^{3+}$,....).

La face du milieu actif en regard du moyen de couplage est par exemple traitée anti-reflet à la longueur d'onde de pompage et réfléchissante à la longueur d'onde laser et la face du milieu actif à l'opposé est par exemple traitée antireflet à la longueur d'onde laser.

L'invention concerne aussi un procédé de fabrication d'un milieu actif utilisé dans les lasers. Il est caractérisé en ce qu'il comporte au moins une étape de réalisation d'un ou de plusieurs morceaux d'une matrice dopée et d'une matrice non dopée de façon à obtenir un milieu actif comportant une ou plusieurs zones ou volume ayant une dimension et/ou une répartition des dopants choisie pour obtenir un mode transversal de la cavité laser.

L'étape de réalisation peut être une étape d'assemblage réalisée par collage ou par adhérence moléculaire ou encore par diffusion bonding.

Selon un autre mode de fabrication l'étape de réalisation est une étape de préforme de fibre à saut d'indice ou de préforme de fibre à gradient d'indice des dopants.

Utilisation du laser présentant l'une des caractéristiques mentionnées précédemment pour amplifier un ou plusieurs faisceaux de type laser.

Le laser selon l'invention présente notamment les avantages suivants :

• déposer la lumière de pompe dans un volume compatible avec un fonctionnement dans le mode fondamental ($TEM_{00}$) et favoriser ce mode par rapport aux ordres supérieurs,
• réaliser un système de focalisation simple, indépendant de la structure de la barrette de laser (moyens de pompage) et potentiellement peu onéreux,
• s'affranchir du problème de la divergence de la lumière incidente sur le milieu laser sans avoir à utiliser des matériaux fortement dopés,
• déposer l'énergie de pompage dans un volume important en comparaison avec les lasers selon l'art antérieur et diminuer ainsi les aberrations optiques d'origine thermique, l'énergie se répartissant dans un volume plus important,
• ne pas dépasser le seuil de dommage (ou endommagement) du matériau laser malgré des puissances de pompe importantes,

D'autres avantages et caractéristiques de l'invention apparaîtront plus clairement dans la description faite à titre d'exemple nullement limitatif à la lecture des figures annexées où :

• la figure 1 représente un exemple de diode laser selon l'art antérieur,
• la figure 2 est un schéma d'un exemple d'architecture d'un laser selon l'invention,
• les figures 3a et 3b représentent la propagation d'un rayon lumineux dans le milieu actif dopé de manière non homogène,
• la figure 4 montre une variante de diode laser de pompage,
• la figure 5 illustre deux exemples d'optique de couplage connues de l'Homme du métier, et
• les figures 6 et 7 représentent deux exemples de schéma utilisant le laser selon l'invention comme amplificateur.

De manière à mieux faire comprendre le principe de fonctionnement du laser selon l'invention, la description qui suit à titre d'exemple illustratif et nullement limitatif concerne un laser pompé diode associé à l'aide d'une optique de couplage simple à un milieu laser actif dopé non-uniformément afin notamment de privilégier le mode transversal $TEM_{00}$ de la cavité laser.

La figure 2 représente un exemple d'architecture d'un module laser selon l'invention. Ce module est composé d'un milieu laser actif 3 dopé de manière non homogène et favorisant un mode laser particulier tel que le mode transversal $TEM_{00}$, d'une diode laser de pompe 4, de moyens 5 de couplage du faisceau de pompe issu de la diode laser de pompe 4 au milieu laser actif 3. La cavité du laser est fermée par un miroir 6.

Le miroir 6 est par exemple disposé dans l'axe optique du laser, perpendiculairement au faisceau laser. Il présente des caractéristiques de transmission adaptées pour optimiser le fonctionnement du laser.

### Diode laser de pompage

La diode laser de pompage 4 peut être une diode laser unitaire, ou un assemblage de diodes laser (barrettes, empilement de barrettes, plaques à émission par la surface,....) tel que décrit par exemple à la figure 1, ou encore tout assemblage de diodes ou de diodes unitaires. Le faisceau émis par une telle structure est par exemple remis en forme avant d'être transmis au milieu actif laser.

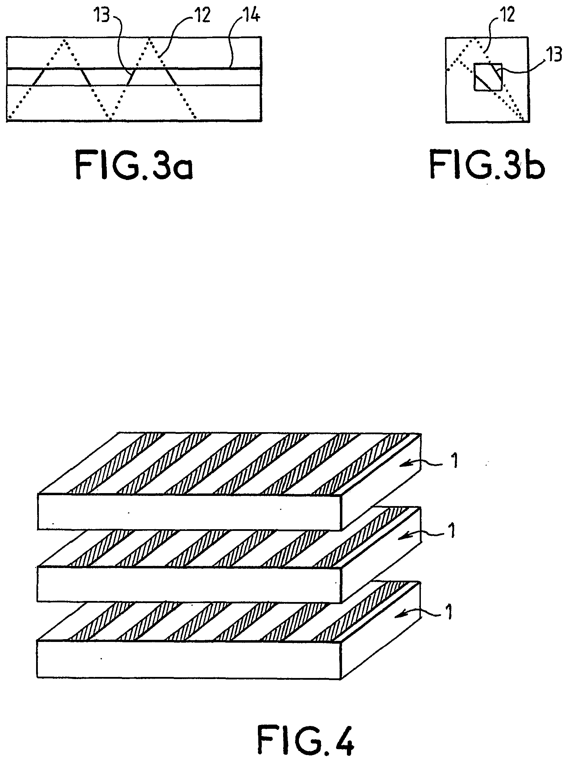

La diode laser peut aussi se présenter sous une forme de plusieurs barrettes disposées de façon telle que l'émission ait lieu dans les trois dimensions. Un exemple d'une telle structure est donné à la figure 4, une telle structure pouvant être utilisée avec ou sans optique de couplage.

### Moyens de couplage

Les moyens de couplage 5 sont adaptés au type de la diode laser de pompage utilisée. Pou un pompage de type longitudinal, il est par exemple possible d'utiliser un concentrateur de lumière tel que décrit dans une des références suivantes :

> [1] le document ayant pour titre " High efficiency $TEM_{00}$ Nd :$YVO_4$ laser longitudinally pumped by a high power laser diode array ", SPIE Proceeding,
> [2] le document ayant pour titre " Nonimaging optics III : Maximum Efficiency Light Transfer ", 1995 ayant pour auteurs G.Feugnet, C.Bussac, M.Schwartz, C.Larat et J.P Pocholle ou publié dans la revue Opt.Lett.20, pp 157-159 en 1995.

La dimension du concentrateur 5 correspondant à la largeur du barreau laser dans le plan parallèle $D_{\parallel}$ est par exemple égale à 1,5 mm. L'épaisseur $e_c$ du concentrateur de lumière est sensiblement constante et égale à 1,5 mm. La face de sortie du concentrateur a une section carrée $s_c$ sensiblement égale à 1,5*1,5 $mm^2$.

### Milieu actif laser

Le milieu laser actif 3 est formé par exemple d'un barreau composite comportant une zone centrale 8 dopée ayant une forme parallélipipédique de section $s_d$ carrée, par exemple, entourée d'une zone périphérique 9 non dopée c'est-à-dire ne comportant pratiquement pas de dopant voir aucun dopant.

Le dopant utilisé pour le milieu actif est choisi par exemple parmi un ou plusieurs des ions de la liste suivante : ($Nd^{3+}$, $Yb^{3+}$, $Er^{3+}$, $Ho^{3+}$, $Th^{3+}$,....).

Le milieu laser actif est par exemple un milieu solide présentant une ou plusieurs transitions laser (YAG :Nd, $YVO_4$ :Nd, saphir :Ti, etc) et connu de l'Homme du métier.

La zone dopée 8 possède une longueur $L_d$ sensiblement égale à la longueur $L_l$ du milieu laser actif, une section $s_d$, et un volume $V_d$ correspondant à $s_d * L_d$. La lumière de pompe est déposée ou absorbée dans ce volume $V_d$ selon par exemple le schéma décrit aux figures 3a et 3b.

La zone dopée 8 a des dimensions adaptées au mode fondamental de la cavité laser par exemple. Elles peuvent aussi être fixées pour favoriser l'apparition d'autres modes transverses. Sa longueur est par exemple choisie en fonction de la quantité de lumière à déposer et de l'absorption.

### Détermination des dimensions de la zone dopée

Une manière pour déterminer la géométrie et les dimensions de la zone dopée non uniformément et/ou la distribution des dopants comporte par exemple les étapes suivantes :

> ➤ A partir des caractéristiques de la source émissive (diode laser) telles que ses dimensions, ses divergences....concevoir une optique de focalisation. L'optique de focalisation est déterminée par exemple pour avoir une transmission aussi bonne que possible, selon des critères connus de l'Homme du métier. Typiquement, la lumière est focalisée sur une tache dont la section $s_l$ est de quelques millimètres carrés,
>
> ➤ Adapter la section du barreau non uniformément dopé aux dimensions de la tache de la lumière.
>
> > ➤ Par exemple, la section du barreau peut être sensiblement carrée, égale ou légèrement plus grande que celle de la face de sortie du concentrateur,
> >
> > ➤ Pour un barreau cylindrique, le diamètre est sensiblement égal ou légèrement supérieur à la diagonale de la face de sortie du concentrateur,
> >
> > ➤ Les dimensions peuvent aussi être choisies pour tenir compte des tolérances de positionnement du barreau devant le concentrateur et la qualité des arêtes du barreau.

➢ Dans le cas d'une focalisation utilisant une lentille, la section du barreau est adaptée pour que la transmission T à travers une ouverture fictive de dimensions identiques soit de l'ordre de 100%

avec

$$T = \iint_{\substack{\text{section de} \\ \text{l'ouverture}}} I(x,y)dxdy \bigg/ \iint_{\infty} I(x,y)dxdy$$

où I(x,y) est la répartition de l'intensité au point de focalisation de la lumière,

➢ Le rapport r entre les dimensions de la zone dopée et celles de la zone non dopée est défini en tenant compte des caractéristiques du rayonnement de pompe prises après l'optique de couplage 5, des caractéristiques spectroscopiques du matériau laser et des contraintes technologiques liées à la réalisation du barreau non uniformément dopé. Les caractéristiques spectroscopiques du matériau laser peuvent être enregistrées au cours d'essais préalables par des méthodes connues de l'Homme du métier.

➢ Le processus de détermination du rapport r se déroule par exemple de manière itérative, et comporte par exemple les étapes suivantes :

➢ au cours d'une première étape a), fixer la valeur du rapport r à une valeur $r_0$,

➢ calculer (deuxième étape b)) la répartition d'énergie de pompe dans le barreau et les effets thermiques associés à partir de cette valeur, en mettant en oeuvre un programme de tracé de rayon et un programme de calculs thermiques,

➢ au cours d'une troisième étape c), concevoir une cavité laser dont le mode TEM$_{00}$ est proche des dimensions de la zone dopée par exemple à l'aide d'un programme de calcul de cavité laser prenant en compte les effets thermiques,

➢ si le mode TEM$_{00}$ déterminé est différent ou trop éloigné, changer la valeur du ratio choisie initialement et recommencer les étapes a) à c). La valeur de la longueur de la cavité laser peut en effet être limitée pour des raisons d'encombrement.

Les différentes méthodes de calcul mises en oeuvre dans les étapes précédemment énoncées sont connues de l'Homme du métier.

Lors de la détermination de la valeur du rapport r, il est nécessaire de tenir compte des contraintes suivantes :

• l'influence de sa valeur sur la longueur du barreau nécessaire pour absorber l'énergie sachant que cette longueur peut être limitée pour des raisons de technologie,
• l'influence de sa valeur sur l'énergie absorbée par unité de longueur qui doit demeurer largement inférieur au seuil de dommage optique.

Pour obtenir une bonne discrimination entre le mode fondamental de la cavité et les modes d'ordre supérieurs, favorisant ainsi le fonctionnement TEM$_{00}$, les dimensions de la zone dopée sont choisies en fonction des dimensions du mode fondamental de la cavité laser.
Ainsi, la section $s_d$ de la zone dopée est de préférence inférieure ou égale à la section $s_m$ du mode fondamental de la cavité. Elle peut aussi être légèrement supérieure ou supérieure à la section du mode fondamental et associée à un autre dispositif de sélection.
La section $s_m$ du mode fondamental correspond par exemple à la section du faisceau laser prise à environ 13,6 % du maximum.
Les étapes décrites en relation avec une géométrie carrée peuvent aussi être appliquée dans le cas d'une géométrie cylindrique, en considérant dans ce cas la section cylindre de la zone dopée.
L'interface entre la zone dopée 8 et la zone périphérique 9 sera réalisée de manière à minimiser les pertes susceptibles de gêner ou de détériorer le fonctionnement du laser, selon des techniques connues de l'Homme du métier.
Les dimensions de la zone périphérique 9 sont choisies par exemple en fonction des performances de l'optique de focalisation, par exemple la tache de focalisation, la divergence du rayonnement après le point de focalisation. La section $S_{nd}$ et $S_d$ est sensiblement égale à la section $S_c$ de la face du concentrateur disposée en regard. La longueur $L_{nd}$ de la zone non dopée correspond par exemple à la longueur du matériau ou milieu actif formant le laser. Elle peut correspondre à la longueur $L_d$ de la zone dopée.
Sans sortir du cadre de l'invention, le dopage peut aussi être obtenu sous la forme d'un gradient de dopants répartis de manière non homogène dans le matériau formant le milieu actif. Le gradient, la répartition des dopants ainsi que leur nature seront déterminés en fonction du mode de fonctionnement retenu pour le laser.
Selon une autre variante de réalisation, le barreau comprend au moins à une de ses extrémités une section totalement non dopée. Cette technique permet de diminuer les déformations aux extrémités d'un barreau. Le contact entre les sections non dopées et les sections dopées de manière non homogène peut être réalisé par une technique de diffusion bonding connue de l'Homme du métier.
Les deux faces externes 10, 11 du barreau composite sont polies pour guider la lumière de pompe par réflexion totale ou pratiquement totale.

La face 10 du barreau composite qui se trouve en regard du concentrateur 5 est traitée au moyen d'un traitement anti-reflet à la longueur d'onde de pompage et pour être totalement réfléchissante à la longueur d'onde laser.

La face opposée 11 du barreau est traitée à l'aide d'un traitement anti-reflet à la longueur d'onde laser. Cette face peut être polie inclinée afin que le faisceau ait une valeur d'angle d'incidence proche de la valeur de Brewster. Lors du montage du barreau laser les précautions nécessaires habituelles seront prises pour éviter qu'une partie du faisceau ne se propage dans un autre milieu accolé.

Les figures 3a et 3b schématisent un exemple d'un trajet de la lumière pompe dans le milieu laser actif comportant une zone dopée centrale de forme parallélépipédique telle que représentée sur la figure 2. Lors de sa propagation dans le barreau laser, le faisceau laser ne traverse pas nécessairement la zone non dopée à chaque réflexion. La puissance de la pompe est déposée uniquement dans la zone centrale dopée ce qui favorise le fonctionnement $TEM_{00}$. De plus, une telle structure permet de s'affranchir de la divergence de la lumière de pompe incidente sur le milieu composite.

Ainsi, sur les trajets 12 en pointillés il n'y pas d'absorption de lumière alors que sur les trajets 13 des rayons lumineux représentés en traits pleins le rayon lumineux est absorbé. La lumière de pompe est guidée par réflexion sur les faces latérales du milieu laser, réflexion totale interne ou sur un traitement diélectrique et effectue aussi un trajet en zigzag dans le barreau composite en déposant de l'énergie uniquement dans la zone dopée 8. Après un nombre suffisant de réflexions toute la puissance de la pompe sera absorbée.

La géométrie (forme et dimensions) de la zone non dopée est adaptée pour optimiser le nombre de faisceaux la traversant tout en assurant un guidage en réflexion totale.

En comparaison avec les structures à dopage élevé précitées, la puissance de pompe se trouve répartie dans un volume plus grand que le volume habituellement offert par les lasers de l'art antérieur, ce qui permet notamment de réduire les aberrations, les contraintes, les biréfringences d'origine thermique.

Selon une autre variante de réalisation, le milieu actif comporte une zone centrale non dopée et une zone périphérique dopée. Dans ce cas, le trajet lumineux va déposer de l'énergie non plus de façon centrale mais à la périphérie du barreau de composite, favorisant ainsi les modes d'ordre supérieurs. Cet agencement favorise le mode habituellement appelé en couronne.

Selon une autre variante, connue par exemple dans le domaine des fibres dites "double clad", technique décrite par exemple dans le brevet US 4,815,079 la zone dopée est décentrée par rapport à la zone qui guide la pompe ou encore, la zone guidante possède une forme particulière, par exemple en forme de D.

Ces modes de réalisation qui consistent à casser la symétrie du milieu optimisé permettent de diminuer le nombre de rayons lumineux (ou de modes de propagation pour les fibres) qui ne pénètrent jamais dans la zone dopée et ne sont pas absorbés. L'absorption est ainsi augmentée.

Méthode de fabrication d'un barreau composite formant le milieu émissif.

Plusieurs procédés de fabrication peuvent être mis en oeuvre pour réaliser le milieu laser actif.

Une façon de fabriquer un barreau composite dopé de manière non homogène comporte par exemple des étapes d'assemblage de morceaux discrets dopés ou non dopées d'une matrice qui auront été polis avant assemblage.

La matrice est par exemple choisie parmi la liste suivante : YAG, YLF, $YVO_4$, GdCOB, verre.

Les différents morceaux sont assemblés selon la géométrie de dopage souhaitée, par exemple :

- par collage avec une colle d'indice adapté, telle qu'une colle optique connue de l'Homme du métier,
- par adhérence moléculaire,
- par diffusion bonding ou soudure par interdiffusion aux interfaces entre les morceaux. Cette technique offre notamment une résistance importante aux chocs et de faibles pertes aux interfaces.

Une autre manière de procéder reposer sur l'utilisation de techniques utilisées dans les fibres optiques et connues de l'Homme du métier. Ces dernières présentent comme avantage de réaliser une préforme avec une partie dopée et une partie non dopée préforme de fibre à saut d'indice ou encore une préforme avec une transition progressive entre la zone dopée et la zone non dopée telle que la préforme de fibre à gradient d'indice. Les dopants sont distribués sous la forme d'un gradient à l'intérieur de la zone dopée.

Cette préforme peut être tirée pour rendre son diamètre compatible avec les dimensions nécessaires pour cette application. La matrice est par exemple du verre de différentes compositions tel que silicate, phosphate, fluoré ou tout autre matériau pour lequel la technique de tirage est adaptée.

Une telle technique permet notamment de réaliser des zones dopées de section circulaire particulièrement bien adaptée à la section des modes fondamentaux de la cavité.

Dans les différentes applications de l'ensemble laser comportant un laser pompé diode avec un milieu laser selon l'invention, différents moyens de focalisation peuvent être utilisés

Pour réaliser la fonction de focalisation deux approches peuvent être distinguées :

- Une première approche consiste à prendre en compte la nature discontinue de la source lumineuse et à imager chacune des diodes de la barrette. Des systèmes à base de faisceaux de fibres optiques, par injection optique dans une ou plusieurs fibres optiques, d'optiques réfractives telles que des lentilles, des lentilles cylindriques, d'optiques diffractives par exemple des lentilles holographiques, des micro-lentilles, de système par réflexion par exemple des micro-miroirs ou encore toute combinaison de ces systèmes peut être utilisée. Ils permettent d'obtenir une focalisation de la lumière performante car les zones non émissives ne sont pas prises en compte. Ils sont utilisés plus particulièrement pour des barrettes comportant un faible nombre d'émetteurs.

- Une deuxième approche consiste par exemple à considérer la barrette dans sa globalité sans tenir compte de la nature discontinue de la source. Des systèmes à base de lentilles macroscopiques, de concentrateurs correspondent par exemple à cette approche. Ces systèmes présentent l'avantage d'être relativement simples à réaliser. Ils sont aussi utilisables quel que soit le nombre d'émetteurs et la source lumineuse est interchangeable.

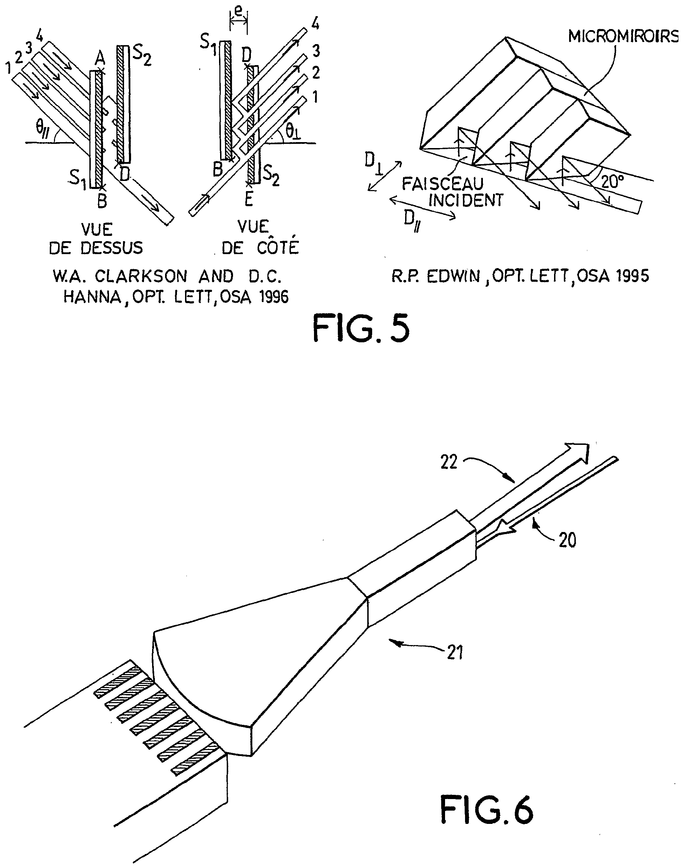

Il est aussi possible d'utiliser des systèmes de redistribution d'étendue ou de remise en forme de l'étendue géométrique du faisceau, par exemple tel que représentés à la figure 5.

Sans sortir du cadre de l'invention, le laser selon l'invention peut aussi être utilisé comme amplificateur d'un faisceau laser.

La figure 6 schématise un exemple de réalisation d'utilisation de structure comportant un barreau dopé non uniformément telle que décrite à la figure 2 pour amplifier un faisceau laser provenant d'une source laser.

Le faisceau laser incident 20 pénètre avec un angle différent de zéro dans la structure amplificatrice 21 et en ressort par exemple avec une direction sensiblement parallèle à la direction incidente sous la forme d'un faisceau laser amplifié 22.

L'angle d'incidence doit être faible pour que le faisceau traverse la totalité ou au moins la majorité de la zone dopée. La section du faisceau peut être légèrement inférieure à la section de la zone dopée.

Les dimensions des zones dopées et non dopées sont choisies pour augmenter l'énergie du faisceau incident tout en conservant le mode laser, par exemple le mode $TEM_{00}$.

Une telle utilisation permet avantageusement d'augmenter l'énergie du faisceau tout en conservant le mode de fonctionnement $TEM_{00}$.

Le faisceau laser amplifié peut être un faisceau laser issu d'un laser femtosecondes.

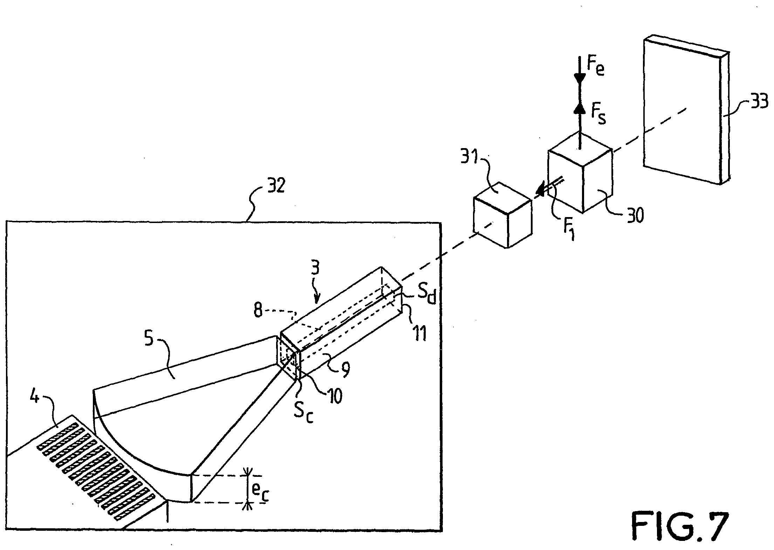

La structure de laser selon l'invention peut aussi être utilisée comme un amplificateur régénératif dont un exemple de réalisation est donné à la figure 7.

Sur cet exemple de réalisation, un faisceau laser $F_e$ à amplifier arrive sur un polariseur 30 adapté pour le transmettre en totalité (100%) ou au moins en majorité à un dispositif tel qu'une cellule de Pockels 31 agissant notamment comme une lame à retard de phase et connue de l'Homme du métier. En entrée de cellule de Pockels le faisceau $F_e$ possède par exemple une polarisation linéaire. Il ressort de cette cellule avec une polarisation circulaire avant d'être transmis au bloc 32 comportant les éléments décrits à la figure 2, notamment le milieu laser dopé de manière non homogène, le miroir 6 étant rempacé par un miroir 33 de fond de cavité disposé après le polariseur. $F_1$ se réfléchit sur la face 10 du barreau dopé de manière non uniforme et ressort par la face 11. Il passe ensuite à travers la cellule de Pockels 32 d'où il ressort avec une polarisation sensiblement perpendiculaire à sa polarisation initiale (celle du faisceau $F_e$). Il est ainsi transmis au miroir 33 de fond de cavité sur lequel il va se réfléchir. Le faisceau $F_1$ est ainsi emprisonné dans la structure comportant le bloc 32 et le miroir 33 la cellule de Pockels permettant de le faire entrer et sortir. Il effectue ainsi plusieurs aller-retours au cours desquels il acquiert de l'énergie, et est donc amplifié. La valeur du gain G obtenu dépend notamment du nombre d'aller-retours effectués et de la structure du barreau dopé de manière non homogène.

Lorsque le faisceau $F_1$ a acquis le gain souhaité, la cellule de Pockels permet de l'extraire, le faisceau de sortie $F_s$ étant égal à $G*F_e$.

Le fonctionnement d'une cellule de Pockels étant connu de l'Homme du métier, il n'a pas été détaillé.

De manière générale, le dispositif lorsqu'il est utilisé comme amplificateur d'un faisceau laser comporte au moins les éléments suivants : une source lumineuse ayant pour fonction notamment d'exciter un milieu laser, un dispositif de couplage du faisceau de lumière issu de la source vers le milieu laser. Le milieu laser utilisé comporte une zone dopée et une zone non dopée au moins, présentant l'une des caractéristiques énoncées en relation avec la figure 2 de façon à augmenter l'énergie de puissance d'un faisceau laser à amplifier.

**Revendications**

1. Laser apte à être pompé longitudinalement comprenant un ou plusieurs milieux actifs lasers sous forme de barreau composite disposés dans une cavité optique et au moins un moyen de pompage (4) émettant au moins un faisceau de pompe vers le ou les milieux actifs lasers (3), des moyens de couplage (5) du ou des faisceaux de pompe avec le milieu actif **caractérisé en ce qu'**au moins un des milieux actifs lasers comporte une ou plusieurs zones (9) non dopées contiguës à une ou plusieurs zones (8) dopées de façon non homogène et **en ce que** la dimension desdites zones (8) dopées et/ou la répartition des dopants est choisie en fonction du mode transversal de la cavité laser souhaité pour assurer une discrimination entre le mode fondamental de la cavité et les modes d'ordre supérieurs.

2. Laser selon la revendication 1 **caractérisé en ce que** la zone dopée (8) est disposée de manière sensiblement centrale dans le milieu actif (3), ses dimensions sont adaptées au mode fondamental de la cavité laser ou au mode transversal et **en ce que** la zone périphérique non dopée a des dimensions adaptées au moyen de couplage (5).

3. Laser selon l'une des revendications 1 ou 2, **caractérisé en ce que** la section carrée ou circulaire $s_d$ de la face d'entrée de la zone dopée qui reçoit le faisceau de pompe est inférieure ou égale à la section circulaire ou elliptique $s_m$ du mode fondamental de la cavité.

4. Laser selon la revendication 1, **caractérisé en ce que** le milieu actif (3) comporte une zone centrale non dopée entourée d'une zone périphérique dopée.

5. Laser selon l'une des revendications précédentes, **caractérisé en ce que** la zone dopée a une forme parallélépipédique ou circulaire ou elliptique.

6. Laser selon l'une des revendications 1 à 5, caractérisé en ce le ou lesdits moyens de pompage (4) comportent une ou plusieurs barrettes de diode et en ce que lesdits moyens de couplage (5) sont constitués d'un concentrateur de lumière adapté à recevoir l'ensemble de la lumière émise desdites barrettes de diodes.

7. Laser selon l'une des revendications 1 à 5, **caractérisé en ce que** lesdits moyens de couplage comportent au moins un des dispositifs choisis dans la liste suivante : un système de focalisation par réfraction ou un système par diffraction ou un système par réflexion ou un système de remise en forme de l'étendue d'un faisceau.

8. Laser selon la revendication 1, **caractérisé en ce que** la distribution des dopants dans le milieu actif est réalisée selon un gradient.

9. Laser selon l'une des revendications précédentes, **caractérisé en ce que** les dopants sont choisis parmi un ou plusieurs des ions de la liste suivante : (Nd3+, Yb3+, Er3+, Ho3+, Th3+,....).

10. Laser selon l'une des revendications précédentes, **caractérisé en ce que** la face du milieu actif en regard du moyen de couplage est traitée anti-reflet à la longueur d'onde de pompage et réfléchissante à la longueur d'onde laser et **en ce que** la face du milieu actif à l'opposé est traitée antireflet à la longueur d'onde laser.

11. Procédé de fabrication d'un milieu actif d'un laser tel que revendiqué à la revendication 1, **caractérisé en ce qu'**il comporte au moins une étape de réalisation d'un ou de plusieurs morceaux d'une matrice dopée de façon non homogène et d'une matrice non dopée de façon à obtenir un milieu actif comportant une ou plusieurs zones ou volume ayant une dimension et/ou une répartition non homogène des dopants choisie pour obtenir un mode transversal de la cavité laser.

## Patentansprüche

1. Laser, der in der Lage ist, in Längsrichtung gepumpt zu werden, beinhaltend ein oder mehrere aktive Lasermedien in Form von Verbundstäben, welche in einem optischen Hohlraum angeordnet sind und mindestens ein Pumpmittel (4), welches mindestens einen Pumpstrahl in Richtung des aktiven Lasermediums oder der aktiven Lasermedien (3) aussendet, Kopplungsmittel (5) des Pumpstrahls oder der Pumpstrahlen mit dem aktiven Medium, **dadurch gekennzeichnet, dass** mindestens eines der aktiven Lasermedien einen oder mehrere nicht dotierte(n) Bereiche (9) besitzt, welche(r) an einen oder mehrere in nicht homogener Weise dotierte Bereiche (8) angrenzt/angrenzen und dadurch, dass die Abmessung der dotierten Bereiche (8) und/oder die Verteilung der Dotierungsmittel angesichts des gewünschten Transversalmodes des Laserhohlraums gewählt ist, um eine Unterscheidung zwischen dem Fundamentalmode des Hohlraums und den Modes höherer Ordnung sicherzustellen.

2. Laser nach Anspruch 1, **dadurch gekennzeichnet, dass** der dotierte Bereich (8) im Wesentlichen mittig im aktiven Medium (3) angeordnet ist, seine Abmessungen für den Fundamentalmode des Laserhohlraums oder für den Transversalmode geeignet sind und dadurch, dass der umlaufende, nicht dotierte Bereich Abmessungen besitzt, die für das Kopplungsmittel (5) geeignet sind.

3. Laser nach einem der Ansprüche 1 oder 2, **dadurch gekennzeichnet, dass** der quadratische oder kreisförmige Abschnitt $s_d$ der Eingangsseite des dotierten Bereichs, welche den Pumpstrahl aufnimmt, kleiner als der oder gleich dem kreisförmige(n) oder elliptische(n) Abschnitt $s_m$ des Fundamentalmodes des Hohlraums ist.

4. Laser nach Anspruch 1, **dadurch gekennzeichnet, dass** der aktive Bereich (3) einen mittleren, nicht dotierten Bereich beinhaltet, welcher von einem umlaufenden, dotierten Bereich umgeben ist.

5. Laser nach einem der vorhergehenden Ansprüche, **dadurch gekennzeichnet, dass** der dotierte Bereich eine Quader- oder Kreis- oder Ellipsenform besitzt.

6. Laser nach einem der Ansprüche 1 bis 5, **dadurch gekennzeichnet, dass** das oder die Pumpmittel (4) eine oder mehrere Diodenanordnung(en) beinhalten und dass die Kopplungsmittel (5) aus einem Lichtkonzentrator gebildet sind, welcher geeignet ist, das gesamte durch die Diodenanordnungen ausgesandte Licht aufzunehmen.

7. Laser nach einem der Ansprüche 1 bis 5, **dadurch gekennzeichnet, dass** die Kopplungsmittel mindestens eine der Vorrichtungen beinhalten, gewählt aus folgender Liste: ein Fokussierungssystem anhand von Refraktion oder ein Beugungssystem oder ein Reflexionssystem oder ein System zur Neuformung der Ausbreitung eines Strahls.

8. Laser nach Anspruch 1, **dadurch gekennzeichnet, dass** die Verteilung der Dotierungsmittel im aktiven Medium entsprechend eines Gradienten erfolgt.

9. Laser nach einem der vorhergehenden Ansprüche, **dadurch gekennzeichnet, dass** die Dotierungsmittel aus einem oder mehreren der Ionen der nachstehenden Liste gewählt sind: (Nd3+, Yb3+, Er3+, Ho3+, Th3+,....).

10. Laser nach einem der vorhergehenden Ansprüche, **dadurch gekennzeichnet, dass** die dem Kopplungsmittel zugewandte Seite des aktiven Mediums bei der Pumpwellenlänge entspiegelt und bei der Laserwellenlänge reflektierend ist und dadurch, dass die gegenüberliegende Seite des Lasermediums bei der Laserwellenlänge entspiegelt ist.

11. Herstellungsverfahren eines aktiven Mediums eines Lasers nach Anspruch 1, **dadurch gekennzeichnet, dass** es mindestens einen Schritt des Herstellens eines oder mehrerer Stücke einer nicht homogen dotierten Matrix und einer nicht dotierten Matrix, so dass ein aktives Medium erhalten wird, welches ein oder mehrere Bereich(e) oder Volumen/Volumina umfasst, welche/welcher/welches eine Abmessung und/oder eine nicht homogene Verteilung der Dotierungsmittel besitzt/besitzen, welche gewählt wird, um einen Transversalmode des Laserhohlraums zu erzielen.

**Claims**

1. Laser suitable for being longitudinally pumped comprising one or more active lasing media in the form of a composite rod, arranged in an optical cavity and at least one pumping means (4) emitting at least one pumping beam toward the active lasing medium or media (3), means (5) for the coupling of the pumped beam or beams with the active medium, **characterised in that** at least one of the active lasing media comprises one or more non-doped zones (9) that are contiguous to one or more non-homogeneously doped zones (8) and **in that** the dimension of said doped zones (8) and/or the distribution of the dopants is chosen on the basis of the desired transverse mode of the laser cavity so as to ensure a discrimination between the fundamental mode of the cavity and the higher-order modes.

2. Laser according to claim 1, **characterised in that** the doped zone (8) is positioned substantially centrally in the active medium (3), its dimensions are adapted to the fundamental mode of the laser cavity or to the transverse mode and **in that** the non-doped peripheral zone has dimensions adapted to the coupling means (5).

3. Laser according to one of the claims 1 or 2, **characterised in that** the square or circular section $s_d$ of the input face of the doped zone that receives the pump beam is smaller than or equal to the circular or elliptical section $s_m$ of the fundamental mode of the cavity.

4. Laser according to claim 1, **characterised in that** the active medium (3) comprises a non-doped central zone surrounded by a doped peripheral zone.

5. Laser according to one of the preceding claims, **characterised in that** the doped zone has a parallelepiped or circular or elliptical shape.

6. Laser according to one of the claims 1 to 5, **characterised in that** said one or more pumping means (4) comprise one or more diode arrays and **in that** the coupling means (5) consist of a light concentrator adapted to receiving all the light emitted by said diode arrays.

7. Laser according to one of the claims 1 to 5, **characterised in that** said coupling means comprise at least one of the devices chosen from the following list: a refractive focusing system or a system working by diffraction or a system working by reflection or a system for reshaping the extent of a beam.

8. Laser according to claim 1, **characterised in that** the distribution of the dopants in the active medium is made according to a gradient.

9. Laser according to one of the preceding claims, **characterised in that** the dopants are chosen from among one or more of the ions of the following list: (Nd3+, Yb3+, Er3+, Ho3+, Th3+, ...).

**10.** Laser according to one of the preceding claims, **characterised in that** the face of the active medium facing the coupling means is treated so as to be anti-reflective at the pumping wavelength and reflective at the laser wavelength, and **in that** the opposite face of the active medium is treated so as to be anti-reflective at the laser wavelength.

**11.** Method for the manufacture of an active medium of a laser according to claim 1, **characterised in that** it comprises at least one step for the making of one or more pieces of a non-homogeneously doped matrix and a non-doped matrix so as to obtain an active medium comprising one or more zones or volumes having a dimension and/or a nonhomogeneous distribution of the dopants chosen to obtain a transverse mode of the laser cavity.

FIG.1

FIG.2

FIG.3a

FIG.3b

FIG.4

EP 1 212 814 B1

VUE
DE DESSUS

VUE
DE CÔTÉ

W.A. CLARKSON AND D.C.
HANNA, OPT. LETT, OSA 1996

MICROMIROIRS

FAISCEAU
INCIDENT

R.P. EDWIN, OPT. LETT, OSA 1995

FIG. 5

FIG.6

13

FIG.7

**EP 1 212 814 B1**

**RÉFÉRENCES CITÉES DANS LA DESCRIPTION**

**Documents brevets cités dans la description**

- JP H07321394 A
- US 4815079 A

**Littérature non-brevet citée dans la description**

- **E.C.HONEA.** Optics Letters. OSA, 1998, 1203
- **E.C.HONEA.** Optics Letters. OSA, 1999, 154
- **G.FEUGNET ; C.BUSSAC ; M.SCHWARTZ ; C.LARAT ; J.P POCHOLLE.** Nonimaging optics III : Maximum Efficiency Light Transfer. *Opt.Lett.,* 1995, vol. 20, 157-159